(19) Europäisches Patentamt
European Patent Office
Office européen des brevets

(11) **EP 3 663 431 A1**

(12) **EUROPÄISCHE PATENTANMELDUNG**

(43) Veröffentlichungstag:
**10.06.2020  Patentblatt 2020/24**

(51) Int Cl.:
***C23C 14/54*** *(2006.01)*    ***C23C 14/34*** *(2006.01)*
***C23C 14/50*** *(2006.01)*    ***H01J 37/34*** *(2006.01)*
***H01J 37/32*** *(2006.01)*

(21) Anmeldenummer: **18210778.9**

(22) Anmeldetag: **06.12.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Singulus Technologies AG**
**63796 Kahl am Main (DE)**

(72) Erfinder:
• **Ocker, Berthold**
  **63454 Hanau (DE)**
• **Dr. Maaß, Wolfram**
  **63589 Linsengericht (DE)**
• **Dr. Hohn, Oliver**
  **63584 Gründau (DE)**

(74) Vertreter: **Vossius & Partner**
**Patentanwälte Rechtsanwälte mbB**
**Siebertstrasse 3**
**81675 München (DE)**

(54) **VERFAHREN ZUR SUBSTRATBESCHICHTUNG**

(57)    Die Erfindung betrifft ein Verfahren zur Bestimmung eines Geschwindigkeitsprofils für die Bewegung eines zu beschichtenden Substrats relativ zu einer Beschichtungsquelle.

Fig. 1a

EP 3 663 431 A1

## Beschreibung

Die Erfindung betrifft ein Verfahren zur Bestimmung eines Geschwindigkeitsprofils für die Bewegung eines zu beschichtenden Substrats relativ zu einer Beschichtungsquelle sowie eine Vorrichtung und ein Verfahren zum Beschichten eines Substrates, insbesondere zum Beschichten mit dünnen Schichten magnetischer oder nichtmagnetischer Werkstoffe, mit dem Ziel, eine extrem gute Schichtdickengleichmäßigkeit auf großen Substraten unter Produktionsbedingungen zu erreichen. Die in Frage kommenden Substratgrößen sind z.B. in der Halbleiterindustrie Siliziumwafer mit einem Durchmesser von 300 mm. Der Übergang zu Wafergrößen mit einem Durchmesser von 450 mm findet z.Zt. bereits statt. Extrem hohe Anforderungen an die Schichtdickengleichmäßigkeit werden z.B. bei der Herstellung von TMR (Tunnel Magneto-Resistance) Schichtsystemen gestellt, bei denen die Tunnelbarriere eine Dicke von nur 1 nm und sogar darunter haben muss und gleichzeitig Abweichungen von der Zielschichtdicke von weniger als 0,1% über die gesamte Substratgröße für die Homogenität des TMR Effektes erforderlich sind. Eine andere Anwendung, bei der es um die Herstellung sehr dünner Schichten mit extrem guter Schichtdickengleichmäßigkeit geht, ist die Herstellung von EUV (Extreme Ultra Violett) Spiegeln. Auch bei der Herstellung von Solarzellen für Photovoltaikanlagen mittels Dünnschichttechnologie werden bei einzelnen Prozessschritten dünne Schichten mittels Kathodenzerstäubung auf große Substrate aufgebracht. Auch wenn die Anforderungen an die Schichtdickengleichmäßigkeit bei weitem nicht so groß sind wie in der Halbleiterindustrie, verbessert eine gute Homogenität der Schichten die Performance dieser Module. Bei diesen und weiteren Anwendungen kann die hier vorgestellte Erfindung im Prinzip vorteilhaft angewendet werden.

Aus der WO 03/071579 A1 ist eine Vorrichtung zum Beschichten von Substraten bekannt, bei der unter Verwendung einer rechteckigen Langkathode Substrate in definiertem Abstand geradlinig und senkrecht zur Längsausrichtung durch den Beschichtungsbereich der Kathode hindurchbewegt werden. Im englischen Sprachgebrauch wurde dieses Verfahren mit dem Begriff "Linear Dynamic Deposition" (LDD) benannt. Mit dieser Methode gelingt es, extrem dünne Schichten (bis unter 1 nm Schichtdicke) mit sehr guter Schichtdickengleichmäßigkeit auf große Substrate (Ø 300 mm technisch realisiert) aufzubringen. Die Methode kann auf alle Materialien angewendet werden, für die eine Beschichtung mittels Kathodenzerstäubung möglich ist. Weitere Vorteile der LDD-Methode sind z.B. in der WO 2012/041920 A1 beschrieben.

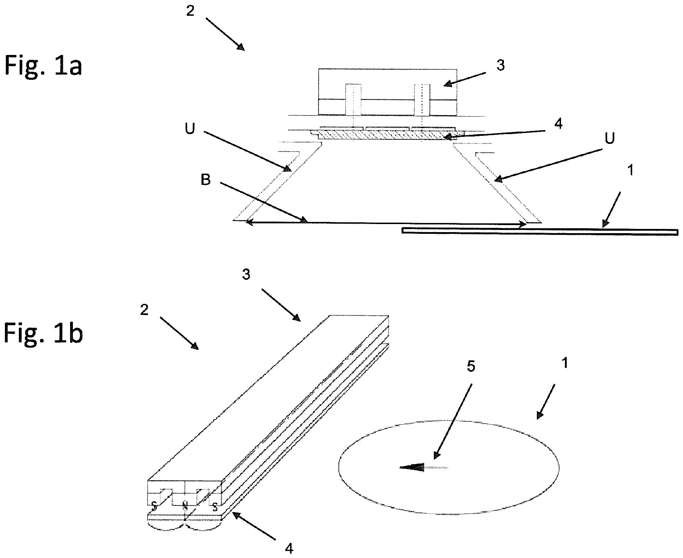

Für die Linear Dynamic Deposition Methode ist es charakteristisch, dass langgestreckte Magnetron-Kathoden für die Beschichtung verwendet werden. Es handelt sich dabei um Kathoden mit rechteckigem Target, bei denen mithilfe von Permanentmagneten ein spezielles Magnetfeld erzeugt wird, um den Zerstäubungseffekt zu vergrößern. Schematisch ist eine solche Anordnung beispielhaft in Fig. 1 gezeigt. Bedingt durch den Aufbau dieser Kathoden ergibt sich, dass eine minimale Breite des Targets von ca. 50 mm kaum unterschritten werden kann. Typische Targetbreiten im industriellen Bereich liegen zwischen 80 mm und 150 mm. Je nach Anwendung und Anlagentyp können die Targetbreiten auch größer sein. Der Bereich, in dem in Richtung der Targetbreite beschichtet wird, ist deutlich größer als die Targetbreite selbst. Er ergibt sich unter anderem vor allem aus dem Abstand zwischen dem Target und dem Substrat. Aus praktischen Gründen wird dieser Bereich allerdings meist durch Blenden begrenzt. Typisch ist eine Beschichtungsbreite, die zweimal so groß ist wie die Targetbreite.

Die Bezeichnung "langgestreckte Kathode" beinhaltet, dass die Länge des rechteckigen Targets mindestens der zweifachen Breite entspricht. Typischerweise liegt aber die Länge bei ca. dem Vierfachen der Breite.

Im industriellen Bereich, speziell in der Halbleiterindustrie, handelt es sich bei den Substraten um runde Siliziumwafer. Diese Wafer haben einen Durchmesser von 200 mm bzw. 300 mm. Einige große Halbleiterhersteller verwenden bereits Wafer mit einem Durchmesser von 450 mm. Daraus ergibt sich ein typisches Verhältnis von 0,5 bis 3 oder größer für Waferdurchmesser zu Beschichtungsbereich.

Im Stand der Technik gibt es zwar verschiedene Ansätze, die Dicke abgeschiedener Schichten zu kontrollieren. So offenbart beispielsweise die WO 2012/072120 A1 ein Verfahren, bei dem z.B. die Dicke der bereits abgeschiedenen Schicht gemessen wird und in einem geschlossenen Regelkreis ("closed loop") die Beschichtungsparameter angepasst werden. Jedoch wurde die Aufgabe, eine extrem gute Schichtdickengleichmäßigkeit mit der LDD oder ähnlichen Methoden zu erreichen, im Stand der Technik nicht gelöst. Mit der vorliegenden Erfindung wird nun ein verbessertes Verfahren (sowie eine verbesserte Vorrichtung zur Durchführung dieses Verfahrens) bereitgestellt, das diesem Problem Rechnung trägt. Die Lösung der Aufgabe besteht im Wesentlichen darin, auf der Basis der Physik des Beschichtungsvorganges praxisnaher Beschichtungsanordnungen (siehe oben) und unter Verwendung von gemessenen Werten für die Ortsabhängigkeit der Schichtdicke den Verlauf der Geschwindigkeit des Substrates $v(x_m)$ so festzulegen, dass die erforderliche Schichtdickengleichmäßigkeit erreicht wird. Das Verfahren erlaubt es ebenfalls, für die angegebenen geometrischen Verhältnisse vorgegebene Schichtdickenprofile in der Bewegungsrichtung des Substrates durch die verfahrensgemäße Bestimmung von $v(x_m)$ technisch zu realisieren.

Bei konstanter Substratgeschwindigkeit $v$ gilt bei der LDD Methode für die Schichtdicke $d$ die Relation $d \sim 1/v$, d.h. die Schichtdicke der aufgebrachten Schicht ist bei größerer Substratgeschwindigkeit kleiner. Die formelmäßige Beschreibung der Ortsabhängigkeit der Schichtdicke in Bewegungsrichtung des Substrates wird im allgemeinen Fall für variable Geschwindigkeit durch

$$d(x'_s) = \int_{-\infty}^{\infty} \frac{R(x'_s; x_m)}{v(x_m)} dx_m \qquad (1)$$

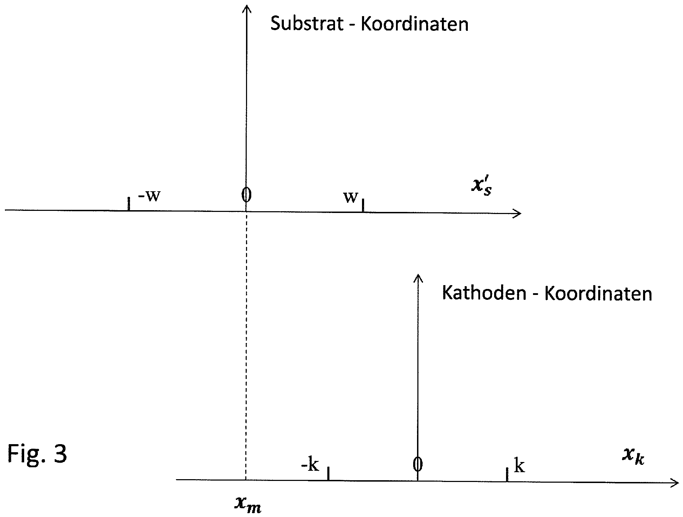

beschrieben. Die verwendeten Koordinaten sind in Fig. 3 erklärt. $x_m$ ist die Position des Substratmittelpunktes im "Kathodensystem" und $x'_s$ ist die Position auf dem Substrat im "Substratsystem". $\pm w$ sind die Begrenzungen des Substrates in x-Richtung. $R(x'_s; x_m)$ ist die Beschichtungsrate, die von der Position des Substratpunktes $x'_s$ unter der Kathode (oder einer anderen Beschichtungsquelle) abhängt. Im Allgemeinen - daraus resultiert die Problemstellung für die vorliegende Erfindung - ändert sich der Verlauf von $R(x'_s; x_m)$ in Abhängigkeit von der Position $x_m$ des Substrates. Der sich daraus ergebende Einfluss auf die Abhängigkeit der Schichtdicke über die Ausdehnung des Substrates (also von $x'_s$) wird im weiteren Text analysiert. $v(x_m)$ ist die auf die Position $x_m$ des Substratmittelpunktes im Kathodensystem bezogene Geschwindigkeit des Substrates, mit der diese Ortsabhängigkeit beeinflusst werden kann.

In Gleichung (1) wird der sehr allgemeine (und "theoretische") Fall beschrieben, dass sich die Rate $R$ über einen unendlichen Bereich erstreckt. Bei allen praktischen Anwendungen ist aber selbstverständlich der Bereich begrenzt, in dem Material von der Kathode abgeschieden wird. Wenn mit $\pm k$ die Grenzen dieses Beschichtungsbereiches beschrieben werden (siehe Fig. 1, 2 und Fig. 3) ergibt sich aus Gleichung (1)

$$d(x'_s) = \int_{-k-x'_s}^{k-x'_s} \frac{R(x'_s + x_m; x_m)}{v(x_m)} dx_m \qquad (1a)$$

bzw.

$$d(x'_s) = \int_{-k}^{k} \frac{R(x^*; x^* - x'_s)}{v(x^* - x'_s)} dx^* \qquad (1b)$$

Die untere und obere Grenze des Integrals in Gl. (1a) ergibt sich durch das "Eintauchen" der Position $x'_s$ in den Beschichtungsbereich bzw. durch das Verlassen desselben, G1. (1b) durch eine Koordinatentransformation. Die Variable $x_m$ bzw. $x^* - x'_s$ nach dem Semikolon in Gl. (1a, b) beschreibt den Effekt der Änderung des Verlaufes von $R$ durch die Substratbewegung. Ohne den Einfluss der Substratbewegung auf die Ratenverteilung $R$ bzw. bei Vernachlässigung desselben, entfällt die Variable $x_m$ bzw. $x^* - x'_s$ nach dem Semikolon und im Vorgriff auf das Folgende wird $R(x^*; ) \equiv R_g(x^*)$. Damit folgt aus Gl. (1b), dass für den Fall einer konstanten Geschwindigkeit $v(x^* - x'_s) = v_0$ keine Ortsabhängigkeit der Schichtdicke $d$ vorhanden sein sollte:

$$d_m = \frac{1}{v_0} \int_{-k}^{k} R_g(x^*) \, dx^* = \frac{C_g}{v_0} \qquad (2)$$

mit $C_g = \int_{-k}^{k} R_g(x^*) dx^*$. Mit $C_g$ ist also eine "Gerätekonstante" definiert. Mit $d_m$ sei ebenfalls im Vorgriff auf das Folgende die mittlere gemessene Schichtdicke bezeichnet. Ohne diesen bereits angesprochenen Einfluss der Substratbewegung müsste daher gemäß Gl. (2) mit der LDD-Methode eine Schichtdickenhomogenität in Bewegungsrichtung ohne Abweichungen erreichbar sein, auch wenn der durch $\pm k$ definierte Beschichtungsbereich in gleicher Größe wie die Substratabmessung in Bewegungsrichtung liegt. Bei der technischen Realisierung einer entsprechenden Vorrichtung (Vakuum-Beschichtungsanlage) muss natürlich eine Langkathode mit einer endlichen Längsausdehnung senkrecht zur Bewegungsrichtung des Substrates (Länge >> Substratabmessung senkrecht zur Bewegungsrichtung) verwendet werden. Eine damit verbundene Abweichung der Schichtdicke in Richtung der Längsausdehnung der Kathode kann weitgehend durch die Anwendung von Aperturblenden kompensiert werden.

In der Praxis gibt es - trotz absolut gleichförmiger Substratgeschwindigkeit - dennoch kleine Abweichungen von der Zielschichtdicke in Bewegungsrichtung des Substrates, die gemäß Gl. (2) nicht durch den geometrischen Aufbau der LDD-Beschichtungsvorrichtung erklärt werden können. Die Ursachen dieser Nichthomogenität der Schichtdicke liegen bei Zerstäubungskathoden sehr wahrscheinlich in kleineren Schwankungen der Dichte des Zerstäubungsplasmas, bedingt durch Veränderungen der Impedanz der Kathodenanordnung bei der Bewegung des Substrates bzw. durch minimale Änderungen des Gasdruckes im Bereich des Plasmas bei der Bewegung. Diese Effekte sind also nicht durch die Geometrie des Ensembles Kathode - Substrat bedingt, sondern durch die Substratbewegung selbst. Auch bei anderen Beschichtungsquellen ändert sich durch die Bewegung des Substrates die unmittelbare Umgebung der Quelle, was in der Praxis zu einem Einfluss auf die Beschichtungsrate führt.

Eine Verbesserung der Schichtdickengleichmäßigkeit z.B. bei der Herstellung einer Schicht mit konstanter Schichtdicke unter 0,5% Abweichung und insbesondere unter 0,3% Abweichung ist aufgrund dieser Effekte äußerst schwierig. Verschiedene Anwendungen der LDD-Beschichtungsmethode erfordern es allerdings, wie eingangs erläutert, die Abweichungen von der Soll-Schichtdicke bis unter 0,1% auf großen Substraten zu erreichen.

Es ist daher insbesondere eine Aufgabe der vorliegenden Erfindung, ein verbessertes Verfahren bereitzustellen, mit dem sich die Schichtdickengleichmäßigkeit besser kontrollieren lässt.

Diese Aufgabe wird durch das Verfahren gemäß Anspruch 1 gelöst. Die abhängigen Ansprüche richten sich auf bevorzugte Ausführungsformen der Erfindung sowie technisch vorteilhafte Merkmale.

Dementsprechend richtet sich die vorliegende Erfindung auf ein Verfahren zur Bestimmung eines Geschwindigkeitsprofils für die Bewegung eines zu beschichtenden Substrats relativ zu einer Beschichtungsquelle während eines Beschichtungsprozesses des Substrats zur Erzielung eines definierten Soll-Schichtdickenprofils. Das Verfahren weist die folgenden Schritte auf:

a) Beschreiben der Beschichtungsrate in Abhängigkeit von den Substratkoordinaten und in Abhängigkeit von der Position des Substrats relativ zur Beschichtungsquelle durch eine Näherungsfunktion mit mehreren Parametern;

b) Beschreiben des zu bestimmenden Geschwindigkeitsprofils durch eine Näherungsfunktion mit einem oder mehreren Parametern;

c) Beschichten eines Substrats mit einem definierten Geschwindigkeitsprofil, wobei das zu beschichtende Substrat während der Beschichtung relativ zu der Beschichtungsquelle geradlinig entlang einer ersten Richtung mit diesem Geschwindigkeitsprofil bewegt wird;

d) Messen des durch die Beschichtung erzielten Ist-Schichtdickenprofils des beschichteten Substrats;

e) Bestimmen eines oder mehrerer der Parameter der Näherungsfunktion für die Beschichtungsrate auf Basis eines Vergleichs des gemessenen Ist-Schichtdickenprofils mit dem definierten Soll-Schichtdickenprofil; und

f) Bestimmen des Geschwindigkeitsprofils durch Bestimmen eines oder mehrerer der Parameter der Näherungsfunktion für das zu bestimmende Geschwindigkeitsprofil auf Basis des oder der in Schritt e) bestimmten Parameter(s).

Die erfindungsgemäße Lösung des Eingangs diskutierten Problems besteht darin, dass der Geschwindigkeitsverlauf der Bewegung des Substrates durch den Beschichtungsbereich der Kathode so verändert wird, dass die Abweichungen zwischen dem definierten Soll-Schichtdickenprofil und dem Ist-Schichtdickenprofil kompensiert werden. Das hierfür erforderliche Geschwindigkeitsprofil wird erfindungsgemäß dadurch ermittelt, dass die Beschichtungsrate durch eine Näherungsfunktion beschrieben wird, deren Parameter durch Abgleich mit einer Messung des durch eine Beschichtung erzielten Schichtdickenprofils bestimmt werden, was wiederum erlaubt, das Geschwindigkeitsprofil auf Basis der genäherten Beschichtungsrate zu bestimmen.

Mit anderen Worten dient das erfindungsgemäße Verfahren der Bestimmung eines optimierten Geschwindigkeitsprofils, das (unter Durchführung ein oder mehrerer Testbeschichtungen) vor der eigentlichen Beschichtung der Substrate während des tatsächlichen Herstellungsprozesses erfolgt. Durch das Verfahren wird ein optimiertes Geschwindigkeitsprofil ermittelt, so dass während des tatsächlichen Herstellungsprozesses das Substrat während der Beschichtung entlang der ersten Richtung mit einer variablen Geschwindigkeit entsprechend diesem erfindungsgemäß bestimmten Geschwindigkeitsprofil bewegt wird, um eine Beschichtung mit einem entlang der ersten Richtung definierten Soll-Schichtdickenprofil zu erhalten. Insbesondere wird erfindungsgemäß nicht, wie beispielsweise in der WO 2012/072120 A1 beschrieben, die Geschwindigkeit des Substrats während der Beschichtung basierend auf einer gleichzeitig erfolgenden Schichtdickenmessung (in einem "closed loop") kontrolliert. Vielmehr liegt das vorbestimmte Geschwindigkeitsprofil bereits vor der tatsächlichen Beschichtung fest, wodurch sich eine minimale Abweichung von dem definierten Soll-Schichtdickenprofil bzw. im speziellen Fall eine größere Homogenität der Schichtdicke über das gesamte Substrat hinweg erzielen lässt.

Die Messung des durch eine Beschichtung erzielten Ist-Schichtdickenprofils (gemäß Schritt d)) kann dabei durch bereits bekannte Verfahren erfolgen. Bei leitfähigen Schichten wird typischerweise die Leitfähigkeit der Schicht vermessen (z.B. mittels "4-point probe"), die proportional zur Schichtdicke ist. Andere Verfahren basieren auf optischen Eigenschaften der Schicht (z.B. Densitometrie, Ellipsometrie).

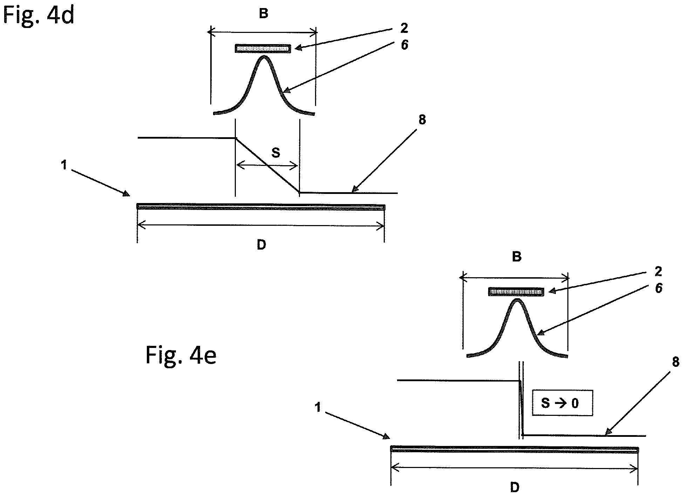

Das erfindungsgemäße Verfahren erlaubt insbesondere auch die Erzielung eines optimierten Schichtdickenprofils im Falle von ausgedehnten Quellen. So ist es bevorzugt, dass die Beschichtung durch die Beschichtungsquelle in einem in der ersten Bewegungsrichtung ausgedehnten Beschichtungsbereich erfolgt, dessen Ausdehnung entlang der ersten Bewegungsrichtung mindestens 100 mm, bevorzugt mindestens 200 mm und besonders bevorzugt mindestens 300 mm beträgt. Soll beispielsweise das definierte Soll-Schichtdickenprofil eine konstante Schichtdicke sein, so führt das erfindungsgemäße Verfahren auch dann noch zu exzellenten Ergebnissen, wenn die Beschichtung durch die Beschichtungsquelle in einem in der ersten Bewegungsrichtung ausgedehnten Beschichtungsbereich mit einer ersten Ausdehnung erfolgt, das Substrat in dieser ersten Bewegungsrichtung eine zweite Ausdehnung aufweist und das Verhältnis der ersten Ausdehnung zur zweiten Ausdehnung mindestens 0,2, bevorzugt mindestens 0,3, stärker bevorzugt mindestens 0,5 und besonders bevorzugt mindestens 1,0 beträgt. Dies gilt auch für definierte Soll-Schichtdickenprofile mit einer variablen Schichtdicke, wobei dann die Substratausdehnung durch eine charakteristische Länge des Profils zu ersetzen ist. D.h., dass die Beschichtung durch die Beschichtungsquelle in einem in der ersten Bewegungsrichtung ausgedehnten Beschichtungsbereich mit einer ersten Ausdehnung erfolgt, das definierte Soll-Schichtdickenprofil eine charakteristische Länge entlang dieser ersten Bewegungsrichtung aufweist und dass das Verhältnis der ersten Ausdehnung zur charakteristischen Länge mindestens 0,2, bevorzugt mindestens 0,3, stärker bevorzugt mindestens 0,5 und besonders bevorzugt mindestens 1,0 beträgt. Als "charakteristische Länge" wird dabei diejenige Länge verstanden, über die sich die Schichtdicke gemäß dem Soll-Schichtdickenprofil signifikant, d.h. um 10% (oder alternativ um 20% oder um mehr als 30%) ändert. So wäre bei einem Profil mit linear ansteigender Schichtdicke (oder auch konstanter Schichtdicke) die charakteristische Länge identisch zur Substratausdehnung. Bei einer "harten" Stufe (vgl. z.B. Fig. 4e)) wäre die charakteristische Länge gleich Null. Im Falle eines Soll-Schichtdickenprofils, bei dem eine möglichst absolut konstante Schichtdicke erreicht werden soll, lassen sich erfindungsgemäß Schichten herstellen, bei denen die Abweichung zwischen der gemessenen und der Soll-Schichtdicke (also zwischen dem Ist-Schichtdickenprofil auf dem beschichteten Substrat und dem definierten Soll-Schichtdickenprofil), gegebenenfalls nach mehreren Iterationen, kleiner als 1,0%, bevorzugt kleiner als 0,5%, stärker bevorzugt kleiner als 0,3% und besonders bevorzugt kleiner als 0,1% ist.

Bevorzugt wird die Beschichtungsrate in Abhängigkeit von den Substratkoordinaten und in Abhängigkeit von der Position des Substrats relativ zur Beschichtungsquelle durch ein Produkt aus mindestens zwei Funktionen approximiert. Dabei enthält das Produkt bevorzugt als ersten Faktor eine geometriebedingte Funktion, die nur von der geometrischen Anordnung der Beschichtungsquelle (d.h. z.B. Breite der Quelle, Abstand von der Substrateebene, Umgebung der Quelle usw.) abhängt und von der Position des Substrats relativ zur Beschichtungsquelle unabhängig ist, und als einen weiteren Faktor eine durch die Substratbewegung bedingte Funktion, die nur von der Position des Substrats relativ zur Beschichtungsquelle abhängt und von der geometrischen Anordnung der Beschichtungsquelle unabhängig ist. Bevorzugt werden die mindestens zwei Funktionen (oder auch nur eine der Funktionen) jeweils durch eine Näherungsfunktion beschrieben, deren konkreter Verlauf durch einen oder mehrere Parameter festgelegt wird. Es ist besonders bevorzugt, dass auch das zu bestimmende Geschwindigkeitsprofil durch eine Näherungsfunktion beschrieben wird, deren konkreter Verlauf durch einen oder mehrere Parameter festgelegt wird. Dabei kann für eine oder mehrere, bevorzugt alle, Näherungsfunktionen jeweils ein Polynom verwendet werden. Als alternative Näherungsfunktionen bieten sich aber auch andere Funktionen an, beispielsweise Cubic Splines Algorithmen.

Bevorzugt werden die Schritte a) bis f), bevorzugt mehrmals, wiederholt, wobei die in Schritt e) bestimmten Parameter des vorigen Durchlaufs in Schritt a) des nachfolgenden Durchlaufs einfließen und das definierte Geschwindigkeitsprofil in Schritt c) des nachfolgenden Durchlaufs dem in Schritt f) des vorigen Durchlauf bestimmten Geschwindigkeitsprofil entspricht.

Bevorzugt ist die Beschichtungsquelle eine PVD-Quelle, stärker bevorzugt eine Zerstäubungskathode und besonders bevorzugt eine Langkathode und/oder eine rechteckige Kathode mit einer langen Achse und einer kurzen Achse, wobei die erste Richtung senkrecht zur langen Achse ausgerichtet ist.

Die vorliegende Erfindung richtet sich auch auf ein Verfahren zum Beschichten eines Substrats. Hierbei wird zunächst ein Geschwindigkeitsprofil für die Bewegung des zu beschichtenden Substrats relativ zu einer Beschichtungsquelle zur Erzielung eines definierten Soll-Schichtdickenprofils festgelegt, wie oben beschrieben. Anschließend wird das Substrat mit diesem zuvor festgelegten Geschwindigkeitsprofil beschichtet, wobei das zu beschichtende Substrat während der Beschichtung relativ zu der Beschichtungsquelle geradlinig entlang einer ersten Richtung mit diesem Geschwindigkeitsprofil bewegt wird.

Dabei ist das definierte Soll-Schichtdickenprofil bevorzugt eine konstante Schichtdicke und auch für das festgelegte Geschwindigkeitsprofil wird bevorzugt eine konstante Geschwindigkeit gewählt, mit der bereits die angestrebte mittlere Schichtdicke abgeschieden wird. Da die Beschichtungsrate der Beschichtungsquelle von der Position des Substrats relativ zur Beschichtungsquelle abhängt und so die Schichtdickenverteilung auf dem Substrat beeinflusst, wird das Geschwindigkeitsprofil gemäß der Schritte a) bis f) so bestimmt, dass durch die Variation der Geschwindigkeit des Substrats der durch die Variation der Beschichtungsrate der Beschichtungsquelle erzeugte Effekt auf die Schichtdickenverteilung zumindest teilweise kompensiert wird.

Die vorliegende Erfindung richtet sich ferner auf eine Vorrichtung zum Beschichten eines Substrats mit einer Beschichtungsquelle, einem Substratträger, der dazu geeignet ist, ein zu beschichtendes Substrat während der Beschichtung relativ zur Beschichtungsquelle geradlinig entlang einer ersten Richtung zu bewegen, und einer Steuerungseinheit, die dazu geeignet und dazu ausgelegt ist, die Geschwindigkeit des Substrats entlang der ersten Richtung während der Beschichtung gemäß einem vorbestimmten Geschwindigkeitsprofil in Abhängigkeit von der Position des Substrats zu variieren, um eine Beschichtung mit einem entlang der ersten Richtung definierten Soll-Schichtdickenprofil zu erhalten, wobei die Steuerungseinheit dazu geeignet und dazu ausgelegt ist, das vorbestimmte Geschwindigkeitsprofil nach dem oben beschriebenen Verfahren zu bestimmen.

Bevorzugte Ausführungsformen der vorliegenden Erfindung werden nachfolgend unter Bezugnahme auf die Figuren näher beschrieben. Es zeigen:

Fig. 1a schematisch die Geometrie einer LDD-Beschichtung in einer Querschnittsansicht für den Fall einer Magnetron-Zerstäubungskathode;

Fig. 1b schematisch die Geometrie der LDD-Beschichtung gemäß Fig. 1a in einer perspektivischen Ansicht;

Fig. 2 schematisch die Bewegung des Substrats durch den Beschichtungsbereich während einer LDD-Beschichtung sowie das zugehörige Geschwindigkeitsprofil;

Fig. 3 die im Kontext der vorliegenden Erfindung verwendeten Koordinatensysteme;

Fig. 4a schematisch die relevanten Größenverhältnisse während einer LDD-Beschichtung;

Fig. 4b schematisch die relevanten Größenverhältnisse während einer LDD-Beschichtung;

Fig. 4c schematisch die relevanten Größenverhältnisse während einer LDD-Beschichtung;

Fig. 4d schematisch die relevanten Größenverhältnisse während einer LDD-Beschichtung;

Fig. 4e schematisch die relevanten Größenverhältnisse während einer LDD-Beschichtung;

Fig. 5a-c schematisch eine LDD-Beschichtung gemäß Stand der Technik;

Fig. 6a einen Konturplot von $R(x\_m; x\_k)$ aus Simulationsrechnung;

Fig. 6b Werte von $R(x\_m; x\_k)$ für verschiedene $x\_m$ aus Simulationsrechnung;

Fig. 7a gemessene Schichtdicken für verschiedene Geschwindigkeitsprofile; und

Fig. 7b die zu Fig. 7a gehörigen Geschwindigkeitsprofile.

Fig. 1 zeigt schematisch die Geometrie eines üblichen LDD-Beschichtungsverfahrens sowohl im Querschnitt (Fig. 1a) als auch in einer perspektivischen Ansicht (Fig. 1b), bei dem ein Substrat 1 relativ zu einer Zerstäubungskathode 2, die eine Magnetanordnung 3 sowie ein Sputtertarget 4 aufweist, bewegt wird. Die geradlinige Bewegung des Substrats 1 entlang einer ersten Richtung relativ zur Zerstäubungskathode wird dabei durch den Pfeil 5 auf dem Substrat 1 angedeutet. Bei der Zerstäubungskathode 2 handelt es sich hier um eine Langkathode, deren lange Achse senkrecht zur Bewegungsrichtung des Substrats 1 ausgerichtet ist. Mit dem Bezugszeichen B (vgl. Fig. 1a) ist der Beschichtungsbereich gekennzeichnet und mit dem Bezugszeichen U (vgl. Fig. 1a) ist die Umgebung der Kathode (z.B. Abschirmbleche) gekennzeichnet.

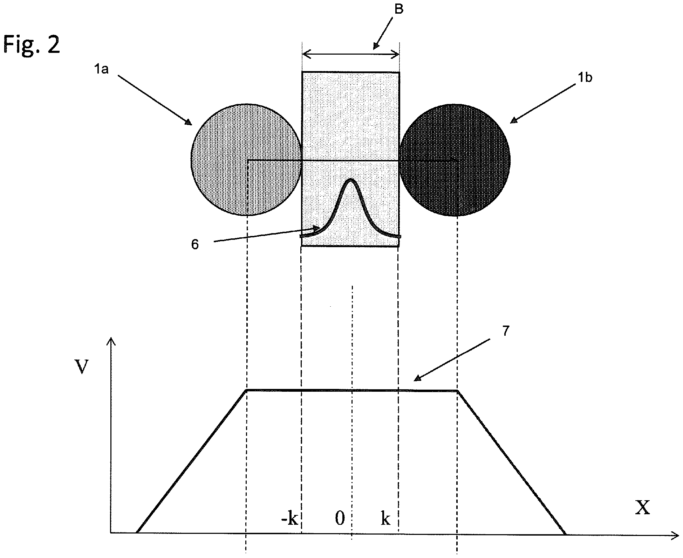

In Fig. 2 wird schematisch die Bewegung des Substrats 1 durch den Beschichtungsbereich B gezeigt, wobei sich das Substrat 1a vor der Beschichtung geradlinig entlang des Pfeils durch den Beschichtungsbereich B bewegt und nach vollzogener Beschichtung mit dem Bezugszeichen 1b versehen ist. Die statische Beschichtungsrate wird dabei schematisch durch die Kurve 6 angedeutet. In Fig. 2 unten ist das Geschwindigkeitsprofil des Substrats in Bezug auf die Zerstäubungskathode gezeigt, wobei das Geschwindigkeitsprofil hier einen Bereich mit konstanter Geschwindigkeit aufweist, der demjenigen Teil des Profils entspricht, in dem eine Beschichtung stattfindet.

Nachfolgend soll nun ein besonders bevorzugtes Ausführungsbeispiel für einen Algorithmus zur Bestimmung des Geschwindigkeitsprofils im Detail erläutert werden. Auch wenn sich das nachfolgende Ausführungsbeispiel auf den Spezialfall des LDD-Beschichtungsverfahrens mit einer Zerstäubungskathode richtet, so lässt sich dieser Algorithmus analog für andere Beschichtungsquellen und insbesondere PVD-Quellen anwenden.

Da, wie oben ausgeführt wurde, mit der LDD Methode auch ohne das hier beschriebene Verfahren bereits eine gewisse Schichtdickengleichmäßigkeit erzielt werden kann, wird im Folgenden der Einfachheit halber von einer Ratenverteilung der Form

$$R(x_k; x_m) = R_g(x_k) * P_v(x_m) \qquad (3)$$

ausgegangen. $R_g(x_k)$ ist die durch die Bewegung des Substrates unbeeinflusste Ratenverteilung als Funktion der Position unter der Kathode $x_k$. $P_v(x_m)$ beschreibt den Effekt der Substratbewegung auf die Gesamtverteilung und hat einen Wert in der Größenordnung von 1, da dieser Effekt nicht groß ist. Das rechtfertigt auch den Ansatz gemäß Gl. (3). Damit ergibt sich aus Gl. (la) bzw. (1b)

$$d(x'_s) = \int_{-k-x'_s}^{k-x'_s} \frac{R_g(x'_s + x_m) * P_v(x_m)}{v(x_m)} dx_m \qquad (1c)$$

bzw.

$$d(x'_s) = \int_{-k}^{k} \frac{R_g(x^*) * P_v(x^* - x'_s)}{v(x^* - x'_s)} dx^* \qquad (1d)$$

Aus Gl. (1d) ergibt sich für $v(x^* - x'_s) = v_0$ ebenfalls die Beziehung (2). Eine Verbesserung der Schichtdickengleichmäßigkeit unter 0,5% Abweichung und insbesondere deutlich unter 0,5% Abweichung ist aufgrund der eingangs diskutierten Effekte insbesondere für den in der Praxis immer vorliegenden Fall eines ausgedehnten Beschichtungsbereiches zwischen $\pm k$ äußerst schwierig. Verschiedene Anwendungen der LDD Beschichtungsmethode - einige davon wurden eingangs bereits angesprochen - erfordern es allerdings, Abweichungen von der Soll-Schichtdicke bis unter 0,1% auf großen Substraten zu erreichen.

Aus der Beziehung (1c) lässt sich, wie im Weiteren gezeigt wird, ein Verfahren zur Bestimmung des Geschwindigkeitsverlaufes $v(x_m)$ gewinnen, mit dem vorgegebene Profile der Schichtdicke $d(x_s)$ mit minimalem Aufwand realisiert werden können. Insbesondere können (auch kleinste) Abweichungen von einer Sollschichtdicke kompensiert und damit eine extrem gute Schichtdickengleichmäßigkeit realisiert werden. Entscheidend ist - und das ist einer der Vorteile der vorliegenden Erfindung -, dass sich das Verfahren auf den in der Praxis immer vorliegenden Fall anwenden lässt, in dem die Ausdehnung des Beschichtungsbereiches von $-k$ bis $+k$ ungefähr in der gleichen Größenordnung ist wie die Ausdehnung des Substrates von $-w$ bis $+w$. In bisher bekannten, der LDD Technologie ähnlichen Verfahren, bei denen durch Variation der Substratgeschwindigkeit eine Schichtdickenanpassung erreicht werden soll, wird immer - meist ohne das explizit zu erwähnen - von einem im Vergleich zum Substrat sehr kleinen Beschichtungsbereich ausgegangen ($k \ll w$).

So wird z.B. in DE 10 2006 036403 A1 eine heuristische Beziehung angegeben, die der selbstverständlichen Relation $d \sim 1/v$ (siehe oben) Rechnung trägt. Diese Beziehung lässt sich als Sonderfall der hier vorgestellten Methode inhaltlich aus Gl. (la) eines unendlich kleinen Beschichtungsbereiches $k \to 0$ ableiten,

$$d_i(x'_s) = 2 * k \; R(0; -x'_s)/v_i(-x'_s), \qquad (4a)$$

wobei der Index $i$ bereits den i-ten Schritt der in DE 10 2006 036403 A1 beschriebenen Iteration zur Schichtdickenoptimierung berücksichtigt. Mit $d_i(x'_s) * v_i(-x'_s) = 2*k* R(0, -x'_s)$ ergibt der nächste Iterationsschritt $i+1$

$$v_{i+1}(x'_s) = v_i(x'_s) * d_i(-x'_s)/d0 \qquad (4b)$$

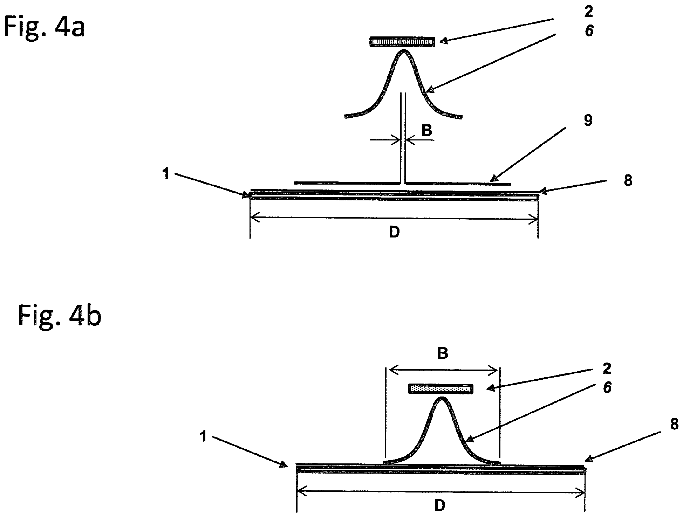

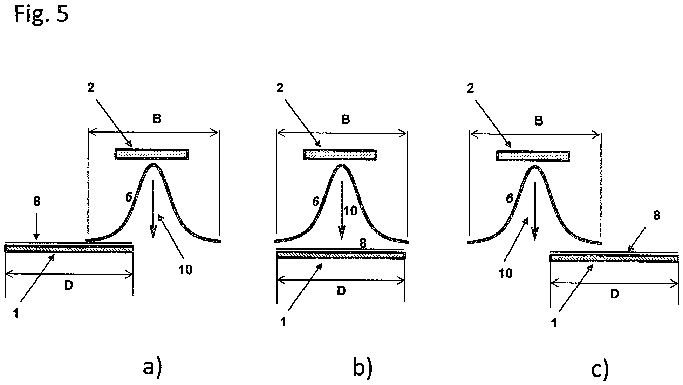

Das ist im Wesentlichen die in DE 10 2006 036403 A1 angegebene Beziehung. $d_{i+1}(-x'_s)$ wurde dabei durch

die Zielschichtdicke **d0** der Iteration ersetzt. Die Vorzeichen begründen sich durch die hier vorliegende Geometrie, bei der sich die Geschwindigkeit des ganzen Substrates immer auf den Substratmittelpunkt bezieht. Wie in DE 10 2006 036403 A1 angemerkt wird, ist diese Rechenmethode für ausgedehnte Beschichtungsquellen nur eine Näherung, ohne die Grenzen dieser Näherung wertemäßig zu definieren. Die Analyse der geometrischen Verhältnisse zeigt sofort die Problematik, siehe Fig. 5: Damit eine Approximation gemäß der Gl. (4b) durchgeführt werden kann, müsste sich der Substratpunkt in dem sehr kleinen Beschichtungsbereich befinden, der die Voraussetzung für die Ableitung der Gl. (4b) ist (siehe auch Fig. 4b). Im Fall des ausgedehnten Beschichtungsbereiches, der hier behandelt wird, ist diese Situation nicht gegeben. Der Substratpunkt müsste sich zur Berechnung gemäß Gl. (4b) zum Beispiel direkt unter der Kathodenmitte befinden. Bei diesem ausgedehnten Beschichtungsbereich wird aber das Substrat bereits beschichtet, wenn die vordere Kante des ausgedehnten Substrates sich noch gar nicht unter der Kathodenmitte befindet (vgl. Fig. 5a), Referenzpfeil nach unten). Damit ist eine Bestimmung einer Geschwindigkeit gemäß Gl. (4b) in dieser Situation nicht möglich. Das ist erst bei der weiteren Bewegung des Substrates möglich, nämlich solange, wie sich ein Punkt des Substrates unter der Kathodenmitte bewegt (vgl. Fig. 5b)). Nachdem die hintere Kante des Substrates die Kathodenmitte verlassen hat (vgl. Fig. 5c)) kann eine Bestimmung der Substratgeschwindigkeit wiederum nicht erfolgen. Diese Analyse zeigt, dass selbst eine näherungsweise Bestimmung von v mittels der Iteration gemäß Gl. (4b) bzw. gemäß DE 10 2006 036403 A1 für den praktisch immer vorliegenden Fall eines ausgedehnten Beschichtungsbereiches und ausgedehnter Substrate nicht möglich ist.

Erfindungsgemäß wird dieser Problematik dadurch Rechnung getragen, dass die unbekannten Funktionen $R(x^*; x^* - x'_s)$ bzw. $R_g(x_k)$ und $P_v(x_m)$ näherungsweise durch "einfache" Funktionen beschrieben werden. Der Verlauf dieser "einfachen" Funktion wird dabei durch Parameter bestimmt, die sich aus der Messung der Schichtdicke von bereits beschichteten Substraten mittels Standardmethoden erforderlichenfalls auch iterativ ermitteln lassen. Unter Verwendung dieser "einfachen" Funktionen und der aus Messwerten ermittelten Parameter kann dann das Geschwindig-keitsprofil $v(x_m)$ ebenfalls näherungsweise unter Verwendung der oben angegebenen Gleichungen festgelegt werden.

Nachfolgend soll nun die Herleitung und die Beschreibung des Algorithmus zur Gewinnung eines optimierten Geschwindigkeitsprofils gemäß einer bevorzugten Ausführungeform der Erfindung im Detail erläutert werden. Dieser Algorithmus ist uneingeschränkt anwendbar für den für die praktische Anwendung der LDD-Technologie wichtigen Fall, bei dem der durch $\pm k$ definierte Beschichtungsbereich nicht deutlich kleiner ist als die Substratgröße oder die angestrebten Strukturen des gewünschten Schichtdickenprofils in Fahrtrichtung sind. Im Beschichtungsbereich wird die Beschichtungsrate durch die Funktion $R(x_k, x_m)$ bzw $R_g(x_k)^* P_v(x_m)$ beschrieben. Grundsätzlich ließe sich $R(x_k, x_m)$ messen, indem man ein Testsubstrat fest (ohne Bewegung) statisch unter der Kathode an unterschiedlichen Positionen $x_m$ platziert und nach Beschichtung das jeweils sich ergebende Schichtdickenprofil an einer ausreichenden Menge von Messpunkten $x_k$ (also in Fahrtrichtung) misst. Dieses Verfahren ist allerdings sehr aufwendig. Die Erfahrung mit der Beschichtung mittels z.B. Kathodenzerstäubung zeigt nämlich, dass statische Beschichtungsprofile mehr oder minder stark von den für die Beschichtung bestimmenden Größen, wie Kathodenleistung, Gasdruck, Targetalter und anderem abhängt. Das Verfahren wäre zudem fehleranfällig, da das gesuchte Beschichtungsprofil auch von der Bewegung selbst abhängen kann. Somit muss in der Praxis davon ausgegangen werden, dass $R(x_k; x_m)$ bzw. die beiden Funktionen $R_g(x_k)$ und $P_v(x_m)$ nicht bekannt sind.

In einer ersten bevorzugten Ausführungsform besteht das erfindungsgemäße Verfahren darin, dass die Funktion $R(x_k; x_m)$ durch ein Polynom näherungsweise beschrieben wird:

$$R(x_k; x_m) \approx \sum_{i,j} R_{ij} * x_k^i * x_m^j \qquad (5a)$$

und die Parameter bzw. Konstanten $R_{ij}$ aus Messwerten bestimmt werden. Das Verfahren soll nachfolgend aber anhand einer weiteren Realisierung erklärt werden, bei der die Funktionen $R_g(x_k)$ und $P_v(x_m)$, sowie anschließend $v(x_m)$ nähe-rungsweise durch Polynome beschrieben werden:

$$R_g(x_k) \approx R_g^{\Sigma}(x_k) = \sum_{i=0}^{iz} R_i * x_k^i \qquad (5b)$$

$$P_v(x_m) \approx P_v^{\Sigma}(x_m) = 1 + \sum_{j=1}^{jz} P_j * x_m^j \qquad (5c)$$

$$v(x_m) \approx v^{\Sigma}(x_m) = \sum_{l=0}^{lz} v_l * x_m^l \qquad (5d)$$

und diese Polynome anstelle der Originalfunktionen in Gl. (1c) entsprechend eingesetzt werden. Die Zahlen iz, jz und lz müssen geeignet festgesetzt werden. Unter der Voraussetzung, dass die Parameter bzw. Konstanten $R_i$, $P_j$ und $v_l$ bekannt sind, lässt sich das Integral in Gl. (1c) z.B. mittels numerischer Verfahren berechnen. Eine Programmierung kann beispielsweise mit Hilfe des Tabellenkalkulationsprogramms EXCEL vorgenommen werden.

Die schrittweise Bestimmung der gesuchten Konstanten $v_l$ wird nachfolgend zunächst für den Fall beschrieben, dass durch die Substratbewegung bedingte Abweichungen von einer (mittleren) Zielschichtdicke $d_z$ minimiert werden sollen.

**Schritt 1:** Dazu wird eine Beschichtung durchgeführt und dabei das Substrat mit konstanter Geschwindigkeit $v_0$ durch den Beschichtungsbereich bewegt. Die Geschwindigkeit $v_0$ wird dabei so festgelegt, dass die mittlere Schichtdicke $d_m$ der angestrebten Zielschichtdicke entspricht.

**Schritt 2:** Die Schichtdicke $d^m(x_{s,h})$ auf dem Substrat (das hochgestellte "$m$" steht für Messung) wird dann mit einer geeigneten Methode an Messpunkten $x_{s,h}$ gemessen.

**Schritt 3:** An jedem dieser Punkte wird dann das Integral in Gl. (1d) numerisch unter Verwendung der Polynome $R_g^{\Sigma}(x_k)$, $P_v^{\Sigma}(x_m)$ und für konstante Geschwindigkeit ($v^{\Sigma}(x_m) = v_0$) berechnet und damit die "approximierten" Schichtdicken $d^s(x_{s,h})$ bestimmt. Zunächst wird bei dieser Berechnung $iz = 0$ gesetzt, d.h. $R_g = R_0$ ist konstant. Diese Einschränkung begründet sich wiederum aus Gl. (2), aus der hervorgeht, dass bei konstanter Substratgeschwindigkeit $v_0$ eine Ortsabhängigkeit von $R_g$ keine Ortsabhängigkeit der Schichtdicke zur Folge hat. Die Parameter $P_j$ werden in diesem Schritt willkürlich angenommen, z.B. $P_j = 0$, $j = 1...6$, d.h. $jz = 6$. Durch die Verwendung der willkürlichen Konstanten in den Polynomen $R_g^{\Sigma}(x_k)$, und $P_v^{\Sigma}(x_m)$ beschreiben diese natürlich in keiner Weise die unbekannten Funktionen $R_g(x_k)$ und $P_v(x_m)$.

**Schritt 4:** Anschließend werden die Parameter $R_0$ und $P_j$, $j = 1...6$ durch Variation so bestimmt, dass die Summe der Abweichungsquadrate

$$\chi^2 = \sum_{h=0}^{m} [d^m(x_{s,h}) - d^s(x_{s,h})]^2 \to MIN! \qquad (6a)$$

minimal wird. Für die Minimalisierung können gängige iterative numerische Verfahren verwendet werden, wie z.B. die Simplex-Methode. Die Berechnung aller Werte von $d^s(x_{s,h})$ gemäß Gl. (1d) muss dabei solange für jeden Parametersatz erfolgen, bis das Minimum nach Gl. (6a) erreicht ist. Als Ergebnis dieser Minimalisierung steht mit den nun gefundenen Werten von $R_0$ und $P_j$, $j = 1...6$ insbesondere der Verlauf von $P_v(x_m)$ näherungsweise zur Verfügung. Die Information für diese Näherung wurde dabei aus den Messwerten $d^m(x_{s,h})$ gewonnen.

**Schritt 5:** Unter Verwendung dieser nun festgesetzten Parameter werden nun die Geschwindigkeitskoeffizienten $v_l$, $l = 0...6$, d.h. $lz = 6$, wiederum durch Minimalisierung wie im Einzelnen unter Schritt 4 beschrieben gemäß

$$\chi^2 = \sum_{h=0}^{m} [d_z - d^s(x_{s,h})]^2 \to MIN! \qquad (6b)$$

bestimmt. Damit ist der Verlauf der Geschwindigkeit $v(x_m) \approx v^\Sigma(x_m)$ gemäß Gl. (5d) näherungsweise gefunden.

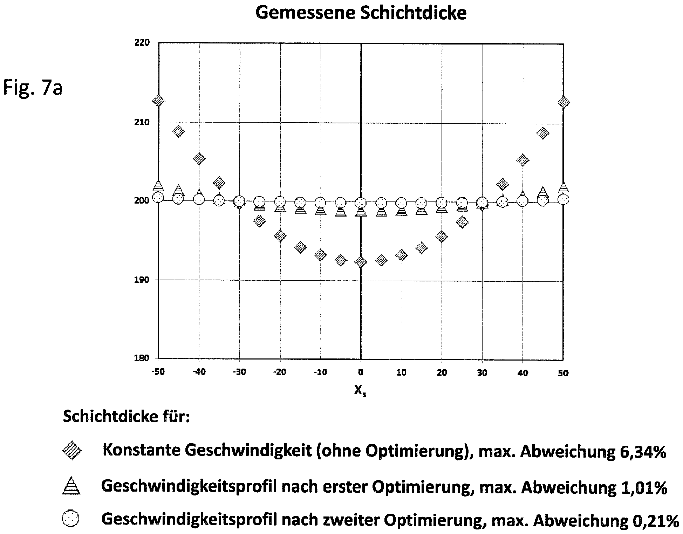

Eine erneute Beschichtung unter Verwendung des Geschwindigkeitsverlaufes $v^\Sigma(x_m)$ zeigt, dass bereits nach diesem ersten Optimierungszyklus eine deutliche Verbesserung der Schichtdickengleichmäßigkeit erreicht wird, siehe Fig. 7a. Falls eine weitere Optimierung erforderlich ist, können die Schritte 1 bis 5 wiederholt werden. Ausgangspunkt für diesen nächsten Durchlauf sind dann also die bereits aus dem ersten Durchgang bekannten Werte für $R_0$ und $P_j$, $j$ = 1...6 sowie das Geschwindigkeitsprofil $v^\Sigma(x_m)$ mit den bereits gewonnenen Parametern $v_l$, $l$ = 0...6. Da jetzt die Geschwindigkeit des Substrates nicht mehr konstant ist und somit die Voraussetzung einer konstanten Substratgeschwindigkeit nicht mehr gegeben ist (siehe Gl. (2)), können jetzt auch die Parameter $R_i$, $i$ = 1...6 in den Minimalisierungsvorgang einbezogen werden, siehe Fig. 7a.

Die Bestimmung der Konstanten $v_l$ für den Fall, dass ein vorgegebenes Schichtdickenprofil in Fahrtrichtung des Substrates durch die Beschichtung mittels variabler Geschwindigkeit erzeugt werden soll, erfolgt in analoger Weise, wie für die konstante Schichtdicke durch Abarbeitung der Schritte 1 bis 5. Allerdings muss jetzt anstelle von Gl. (6b) die Minimalisierung zur Bestimmung der Geschwindigkeitskoeffizienten mittels

$$\chi^2 = \sum_{h=0}^{m} \left[ d_p\left(x_{s,h}\right) - d^s\left(x_{s,h}\right) \right]^2 \qquad (6c)$$

erfolgen. $d_p(x_{s,h})$ ist die Schichtdicke an den Messpunkten $x_{s,h}$, wie sie sich aus dem vorgegebenen Schichtdickenprofil ergeben.

Für die näherungsweise Erfassung von $R(x_k; x_m)$ bzw. der beiden Funktionen $R_g(x_k)$ und $P_v(x_m)$, sowie von $v(x_m)$ können auch andere geeignete Funktionen verwendet werden. Im linearen Fall gemäß der Gl. (5b - d) bietet sich z.B. ein "Cubic Spline" Algorithmus an, bei dem sowohl die Stützstellen als auch die Konstanten der kubischen Segmente für einen Fit gemäß Gleichung (6b) bzw. Gl. (6c) herangezogen werden können. Kriterien für eine Wahl von Näherungsfunktionen werden jeweils sein, dass mit möglichst wenigen Parametern eine gute Beschreibung der unbekannten Originalfunktionen erreicht werden kann.

In Fig. 4a-4e sind schematisch die Größenverhältnisse einiger beispielsweise für die LDD-Beschichtung charakteristischer Dimensionen bzw. Längen an unterschiedlichen beispielhaften Situationen gezeigt. Dabei bezeichnen die Bezugszeichen 1 und 2 (entsprechend Fig. 1) das Substrat und die Zerstäubungskathode. Mit dem Bezugszeichen 6 wird die statische Beschichtungsratenverteilung gekennzeichnet, die unter anderem von der Kathodenbreite abhängt. Da hier die Größenverhältnisse am Beispiel der LDD-Beschichtung diskutiert werden sollen, beziehen sich alle Größen auf die Bewegungsrichtung des Substrats 1 relativ zur Kathode 2. Das Bezugszeichen B bezeichnet die Ausdehnung des Beschichtungsbereiches entlang der Bewegungsrichtung (vgl. auch Fig. 1a). Dasselbe gilt für die Abmessung D des Substrats 1.

In Fig. 4a ist der Fall einer idealen "Linienquelle" dargestellt, der nur durch spezielle Blenden (Bezugszeichen 9) direkt über dem Substrat realisiert werden kann. In diesem Fall gilt B<<D. Mit dem Bezugszeichen 8 ist die Schicht bzw. das Schichtdickenprofil bezeichnet. Bei einer solchen Anordnung wird ein großer Teil des Materialflusses vom Target zum Substrat "ausgeblendet". Das führt zu einer extrem kleinen Beschichtungsrate in Verbindung mit einem großen Materialverlust durch die Blenden. Daher findet diese Anordnung in der Praxis kaum Anwendung. Dieser Fall ist, wie bereits dargelegt, als Spezialfall in der vorgelegten Technik erfasst.

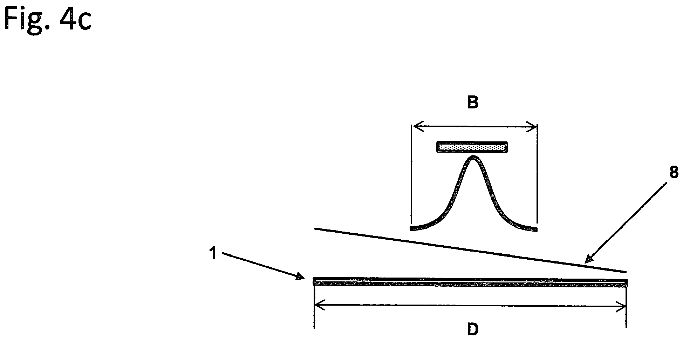

In den Fig. 4b, 4c ist eine typische (bspw. einer Gaussverteilung ähnliche) Beschichtungsrate 6 dargestellt. Fig. 4b zeigt den Fall einer konstanten Soll-Schichtdicke 8, in dem größtmögliche Schichtdickengleichmäßigkeit angestrebt wird. Fig. 4c zeigt den Fall, in dem ein linearer Anstieg 8 (in der Abbildung zur Verdeutlichung stark überhöht) der Schichtdicke über die gesamte Substratbreite hergestellt werden soll mit kleinstmöglicher Abweichung der Schichtdicke von diesem linearen Profil. In beiden Fällen gilt $B \approx D$.

In den Fig. 4d-4e sind beispielhaft alternative Schichtdickenzielprofile 8 (in der Abbildung zur Verdeutlichung stark überhöht) gezeigt. Diese Profile sind typischerweise durch eine charakteristische Länge $S$ gekennzeichnet, die kleiner als die Abmessung $D$ des Substrats 1 sind. Im Fall der Fig. 4d ist diese charakteristische Länge $S$ zwar kleiner als die Beschichtungsbreite $B$, aber noch in der gleichen Größenordnung. Das Schichtdickenzielprofil 8 der Fig. 4e weist dagegen eine scharfe Kante bzw. Stufe auf, für die die charakteristische Länge $S$ des Schichtdickenzielprofils gegen Null geht: $S \rightarrow 0$.

Wie man sich anhand von Fig. 4e leicht klar macht, lässt sich ein präzises Stufenprofil mit perfekt scharfer Kante nicht mit einer Kathode erzielen, die eine ausgedehnte Beschichtungsbreite besitzt, d.h. wenn $B >> S$. Die Beschichtung mit einer ausgedehnten Beschichtungsbreite würde zu einem "Aufweichen" der Stufe im Profil führen. Derartige Profile lassen sich nur mit Hilfe einer (idealen) Linienquelle mit $B \rightarrow 0$ (vgl. Fig. 4a) erzeugen. Allerdings erlaubt es die vorliegende Erfindung die Schichtdicken von Profilen mit entsprechend großer charakteristischer Länge auch mit großen Beschichtungsbreiten, d.h. $B \approx D$, effizient mit größter Präzision herzustellen.

Dass dies durch herkömmliche Verfahren, wie sie beispielsweise in der DE 10 2006 036403 A1 beschrieben sind, nicht möglich ist, verdeutlichen nochmals die Fig. 5a - 5c, die zeigen, dass die Bestimmung eines Geschwindigkeitsprofils $v(x_m)$ auch nicht näherungsweise mit einer einfachen, nur für ideale Linienquellen gemäß Fig. 4a gültige, Methode bestimmt werden kann. Bei einem ausgedehnten Substratbereich wird hier das Substrat bereits beschichtet, wenn die vordere Kante des ausgedehnten Substrates sich noch gar nicht unter der Kathodenmitte befindet (vgl. Fig. 5a). Damit ist die Bestimmung der Geschwindigkeit aus einer abweichenden Schichtdicke unterhalb des Pfeiles (Bezugszeichen 10) nicht möglich. Die Fig. 5b und 5c zeigen den Durchlauf des Substrates 1 durch den ausgedehnten Beschichtungsbereich $B$.

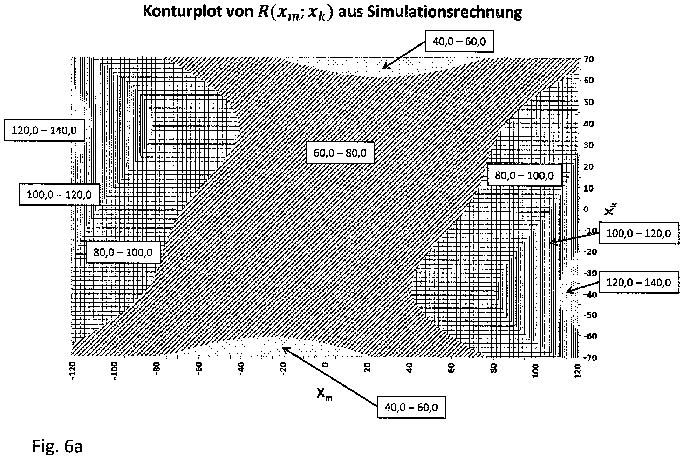

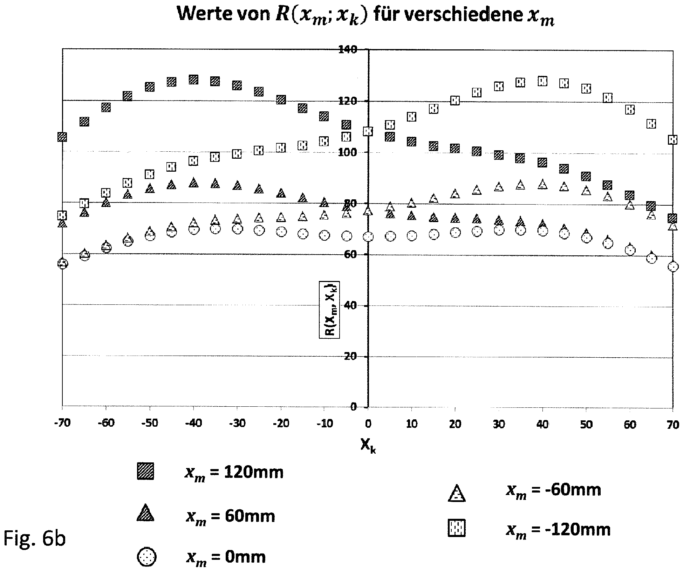

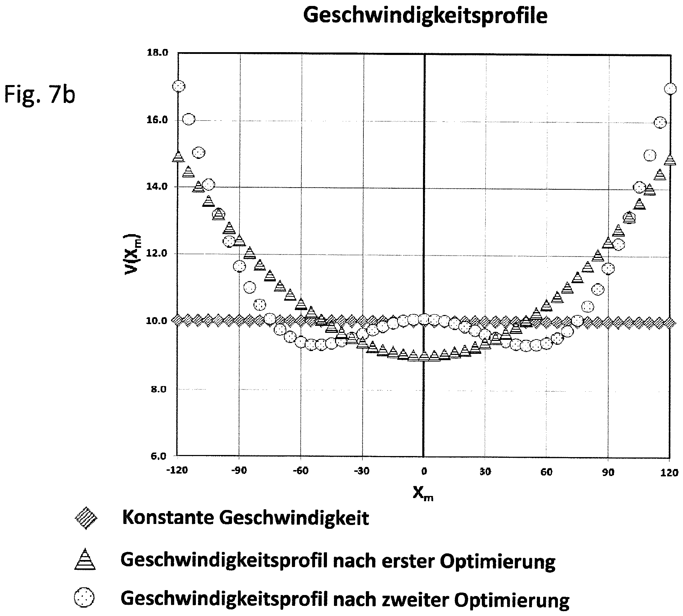

In den Fig. 6 und 7 sind beispielhaft die Ergebnisse einer erfindungsgemäßen Optimierung für den Fall einer konstanten Soll-Schichtdicke dargestellt, mit den Werten k = 70 mm (d.h. mit einem Beschichtungsbereich einer Breite von 140 mm, vgl. Fig. 2) und w = 50 mm (d.h. einer Substratausdehnung von 100 mm, vgl. Fig. 3). Die "Messwerte" $d^m(x_{s,h})$ wurden dabei unter Verwendung einer Simulationsfunktion $R(x_k; x_m)$ hilfsweise berechnet. Die Abhängigkeit dieser Simulationsfunktion orientiert sich dabei an Berechnungsmethoden für die Beschichtungsrate von Längskathoden (siehe z.B. "Schichtdickengleichmäßigkeit von aufgestäubten Schichten - Vergleich zwischen Berechnungen und praktischen Ergebnissen", G. Deppisch, Vakuumtechnik 30 (1981) 106). Die so ermittelte Ausgangsfunktion für die "gemessene" Schichtdicke für ein konstantes, nicht optimiertes Geschwindigkeitsprofil ist in Fig. 7a (rautenförmige Symbole) abgebildet.

Fig. 6a zeigt den "Konturplot" der so ermittelten Werte von $R(x_k; x_m)$. Zur Verdeutlichung der guten Funktionsweise des erfindungsgemäßen Verfahrens wurde der Effekt der Substratbewegung, also die Abhängigkeit $R$ von $x_m$ stark überhöht. So liegen bei dieser Simulation die Minimalwerte von $R$ bei ca. 50 (beliebige Einheiten) und die Maximalwerte bei 130. Eine so starke Veränderung der Rate $R$ durch die Substratbewegung ist in der LDD Praxis normalerweise nicht festzustellen. In Ergänzung zu Fig. 6a zeigt Fig. 6b den Verlauf von $R(x_k; x_m)$ für verschiedene Werte $x_m$. Fig. 7a zeigt die "gemessene" Schichtdicke als Ergebnis der Optimierung in der Reihenfolge ohne Optimierung, nach erster und nach zweiter Optimierung. Trotz der starken Überhöhung bzw. Übertreibung der Abhängigkeit der der Rate $R$ von $x_m$ wird bereits nach dem zweiten Optimierungsschritt eine Schichtdickengleichmäßigkeit von 0,21% erreicht. Fig. 7b zeigt die Fig. 7a entsprechenden Geschwindigkeitsprofile.

**Patentansprüche**

1. Verfahren zur Bestimmung eines Geschwindigkeitsprofils für die Bewegung eines zu beschichtenden Substrats relativ zu einer Beschichtungsquelle während eines Beschichtungsprozesses des Substrats zur Erzielung eines definierten Soll-Schichtdickenprofils, wobei das Verfahren die folgenden Schritte aufweist:

   a) Beschreiben der Beschichtungsrate in Abhängigkeit von den Substratkoordinaten und in Abhängigkeit von der Position des Substrats relativ zur Beschichtungsquelle durch eine Näherungsfunktion mit mehreren Parametern;
   b) Beschreiben des zu bestimmenden Geschwindigkeitsprofils durch eine Näherungsfunktion mit einem oder mehreren Parametern;
   c) Beschichten eines Substrats mit einem definierten Geschwindigkeitsprofil, wobei das zu beschichtende Substrat während der Beschichtung relativ zu der Beschichtungsquelle geradlinig entlang einer ersten Richtung mit diesem Geschwindigkeitsprofil bewegt wird;
   d) Messen des durch die Beschichtung erzielten Ist-Schichtdickenprofils des beschichteten Substrats;
   e) Bestimmen eines oder mehrerer der Parameter der Näherungsfunktion für die Beschichtungsrate auf Basis eines Vergleichs des gemessenen Ist-Schichtdickenprofils mit dem definierten Soll-Schichtdickenprofil; und
   f) Bestimmen des Geschwindigkeitsprofils durch Bestimmen eines oder mehrerer der Parameter der Näherungsfunktion für das zu bestimmende Geschwindigkeitsprofil auf Basis des oder der in Schritt e) bestimmen Parameter(s).

2. Verfahren nach Anspruch 1, wobei die Beschichtung durch die Beschichtungsquelle in einem in der ersten Bewegungsrichtung ausgedehnten Beschichtungsbereich erfolgt, dessen Ausdehnung entlang der ersten Bewegungsrichtung mindestens 100 mm, bevorzugt mindestens 200 mm und besonders bevorzugt mindestens 300 mm beträgt.

3. Verfahren nach Anspruch 1 oder 2, wobei das definierte Soll-Schichtdickenprofil eine konstante Schichtdicke ist und wobei die Beschichtung durch die Beschichtungsquelle in einem in der ersten Bewegungsrichtung ausgedehnten Beschichtungsbereich mit einer ersten Ausdehnung erfolgt und das Substrat in dieser ersten Bewegungsrichtung eine zweite Ausdehnung aufweist und wobei das Verhältnis der ersten Ausdehnung zur zweiten Ausdehnung mindestens 0,2, bevorzugt mindestens 0,3, stärker bevorzugt mindestens 0,5 und besonders bevorzugt mindestens 1,0 beträgt.

4. Verfahren nach Anspruch 1 oder 2, wobei das definierte Soll-Schichtdickenprofil eine variable Schichtdicke ist, wobei die Beschichtung durch die Beschichtungsquelle in einem in der ersten Bewegungsrichtung ausgedehnten Beschichtungsbereich mit einer ersten Ausdehnung erfolgt und wobei das definierte Soll-Schichtdickenprofil eine charakteristische Länge entlang dieser ersten Bewegungsrichtung aufweist und wobei das Verhältnis der ersten Ausdehnung zur charakteristischen Länge mindestens 0,2, bevorzugt mindestens 0,3, stärker bevorzugt mindestens 0,5 und besonders bevorzugt mindestens 1,0 beträgt.

5. Verfahren nach einem der vorigen Ansprüche, wobei die Beschichtungsrate in Abhängigkeit von den Substratkoordinaten und in Abhängigkeit von der Position des Substrats relativ zur Beschichtungsquelle durch ein Produkt aus mindestens zwei Funktionen approximiert wird.

6. Verfahren nach Anspruch 4, wobei das Produkt als einen Faktor eine geometriebedingte Funktion enthält, die von den Beschichtungsquellenkoordinaten abhängt und von der Position des Substrats relativ zur Beschichtungsquelle unabhängig ist, und wobei das Produkt als einen weiteren Faktor eine durch die Substratbewegung bedingte Funktion enthält, die von der Position des Substrats relativ zur Beschichtungsquelle abhängt und von den Beschichtungsquellenkoordinaten unabhängig ist.

7. Verfahren nach Anspruch 5 oder 6, wobei die mindestens zwei Funktionen jeweils durch eine Näherungsfunktion mit einem oder mehreren Parametern beschrieben werden.

8. Verfahren nach einem der vorigen Ansprüche, wobei die Schritte a) bis f), bevorzugt mehrmals, wiederholt werden, wobei die in Schritt e) bestimmten Parameter des vorigen Durchlaufs in Schritt a) des nachfolgenden Durchlaufs einfließen und das definierte Geschwindigkeitsprofil in Schritt c) des nachfolgenden Durchlaufs dem in Schritt f) des vorigen Durchlaufs bestimmten Geschwindigkeitsprofil entspricht.

9. Verfahren nach Anspruch 3, wobei die Abweichung zwischen dem gemessenen Ist-Schichtdickenprofil des beschichteten Substrats von dem definierten Soll-Schichtdickenprofil, gegebenenfalls nach mehreren Iterationen, kleiner als 1,0%, bevorzugt kleiner als 0,5%, stärker bevorzugt kleiner als 0,3% und besonders bevorzugt kleiner als 0,1% ist.

10. Verfahren zum Beschichten eines Substrats mit den folgenden Schritten:

a) Bestimmen eines Geschwindigkeitsprofils für die Bewegung des zu beschichtenden Substrats relativ zu einer Beschichtungsquelle zur Erzielung eines definierten Soll-Schichtdickenprofils nach einem der vorigen Ansprüche; und
b) Beschichten des Substrats mit dem zuvor bestimmten Geschwindigkeitsprofil, wobei das zu beschichtende Substrat während der Beschichtung relativ zu der Beschichtungsquelle geradlinig entlang einer ersten Richtung mit diesem Geschwindigkeitsprofil bewegt wird.

11. Verfahren nach Anspruch 10, wobei das definierte Soll-Schichtdickenprofil eine konstante Schichtdicke ist und wobei das bestimmte Geschwindigkeitsprofil nicht konstant ist.

12. Verfahren nach Anspruch 10 oder 11, wobei die Beschichtungsrate der Beschichtungsquelle von der Position des Substrats relativ zur Beschichtungsquelle abhängt und wobei das bestimmte Geschwindigkeitsprofil derart ausgelegt ist, dass durch die Variation der Geschwindigkeit des Substrats die Variation der Beschichtungsrate der Beschichtungsquelle zumindest teilweise kompensiert wird.

13. Verfahren nach Anspruch 10, 11 oder 12, wobei die durch die Abhängigkeit der Beschichtungsrate der Beschichtungsquelle von der Position des Substrats relativ zur Beschichtungsquelle erzeugte Schichtdickenungleichmäßigkeit durch das vorbestimmte Geschwindigkeitsprofil zumindest teilweise kompensiert wird.

14. Vorrichtung zum Beschichten eines Substrats mit einer Beschichtungsquelle, einem Substratträger, der dazu geeignet ist, ein zu beschichtendes Substrat während der Beschichtung relativ zur Beschichtungsquelle geradlinig entlang einer ersten Richtung zu bewegen, und einer Steuerungseinheit, die dazu geeignet und dazu ausgelegt ist, die Geschwindigkeit des Substrats entlang der ersten Richtung während der Beschichtung gemäß einem vorbestimmten Geschwindigkeitsprofil in Abhängigkeit von der Position des Substrats zu variieren, um eine Beschichtung mit einem entlang der ersten Richtung definierten Soll-Schichtdickenprofil zu erhalten, wobei die Steuerungseinheit dazu geeignet und dazu ausgelegt ist, das vorbestimmte Geschwindigkeitsprofil nach einem Verfahren gemäß den Ansprüchen 1-9 zu bestimmen.

EP 3 663 431 A1

Fig. 1a

Fig. 1b

14

Fig. 2

Substrat - Koordinaten

$-w$      0      w      $x'_s$

Kathoden - Koordinaten

Fig. 3      $-k$      0      $k$      $x_k$

$x_m$

Fig. 4a

Fig. 4b

# Fig. 4c

Fig. 4d

Fig. 4e

Fig. 5

a)  b)  c)

Konturplot von $R(x_m; x_k)$ aus Simulationsrechnung

Fig. 6a

## Werte von $R(x_m; x_k)$ für verschiedene $x_m$

Fig. 6b

$x_m$ = 120mm

$x_m$ = 60mm

$x_m$ = 0mm

$x_m$ = -60mm

$x_m$ = -120mm

EP 3 663 431 A1

**Gemessene Schichtdicke**

Fig. 7a

**Schichtdicke für:**

*◈* Konstante Geschwindigkeit (ohne Optimierung), max. Abweichung 6,34%

△ Geschwindigkeitsprofil nach erster Optimierung, max. Abweichung 1,01%

◎ Geschwindigkeitsprofil nach zweiter Optimierung, max. Abweichung 0,21%

23

Fig. 7b

Geschwindigkeitsprofile

Konstante Geschwindigkeit

Geschwindigkeitsprofil nach erster Optimierung

Geschwindigkeitsprofil nach zweiter Optimierung

Europäisches Patentamt
European Patent Office
Office européen des brevets

## EUROPÄISCHER RECHERCHENBERICHT

Nummer der Anmeldung

EP 18 21 0778

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | DE 10 2006 036403 A1 (ARDENNE ANLAGENTECH GMBH [DE]) 7. Februar 2008 (2008-02-07) * Absätze [0068], [0068] * * Ansprüche 8,9 * * Absatz [0037] - Absatz [0042] * * Absatz [0021] * * Absatz [0003] * * Absätze [0021], [0044] * * Absatz [0032] - Absatz [0033] * ----- | 1-14 | INV. C23C14/54 C23C14/34 C23C14/50 H01J37/34 H01J37/32 |
| X | JP S62 180063 A (ISHIKAWAJIMA HARIMA HEAVY IND) 7. August 1987 (1987-08-07) * das ganze Dokument * ----- | 1,5-8, 10-14 | |
| A,D | WO 2012/072120 A1 (APPLIED MATERIALS INC [US]; LORENZ STEFAN [DE]; SAUER PETER [DE]) 7. Juni 2012 (2012-06-07) * Seite 11, Zeile 6 - Zeile 28 * ----- | 1-14 | |
| A | US 2014/170301 A1 (JO YONG HUN [KR] ET AL) 19. Juni 2014 (2014-06-19) * Absatz [0054] - Absatz [0059]; Abbildungen 4,5 * ----- | 1-14 | RECHERCHIERTE SACHGEBIETE (IPC) C23C H01J |

Der vorliegende Recherchenbericht wurde für alle Patentansprüche erstellt

| Recherchenort | Abschlußdatum der Recherche | Prüfer |
|---|---|---|
| Den Haag | 29. Mai 2019 | Kudelka, Stephan |

KATEGORIE DER GENANNTEN DOKUMENTE

X : von besonderer Bedeutung allein betrachtet
Y : von besonderer Bedeutung in Verbindung mit einer
 anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
 nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
 Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 21 0778

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-05-2019

| Im Recherchenbericht angeführtes Patentdokument | Datum der Veröffentlichung | Mitglied(er) der Patentfamilie | Datum der Veröffentlichung |
|---|---|---|---|
| DE 102006036403 A1 | 07-02-2008 | DE 102006036403 A1<br>EP 2052403 A1<br>EP 2797103 A1<br>WO 2008015159 A1 | 07-02-2008<br>29-04-2009<br>29-10-2014<br>07-02-2008 |
| JP S62180063 A | 07-08-1987 | JP H049867 B2<br>JP S62180063 A | 21-02-1992<br>07-08-1987 |
| WO 2012072120 A1 | 07-06-2012 | TW 201233838 A<br>WO 2012072120 A1 | 16-08-2012<br>07-06-2012 |
| US 2014170301 A1 | 19-06-2014 | KR 20140080816 A<br>US 2014170301 A1<br>US 2016186313 A1 | 01-07-2014<br>19-06-2014<br>30-06-2016 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- WO 03071579 A1
- WO 2012041920 A1
- WO 2012072120 A1
- DE 102006036403 A1

**In der Beschreibung aufgeführte Nicht-Patentliteratur**

- **G. DEPPISCH.** Schichtdickengleichmäßigkeit von aufgestäubten Schichten - Vergleich zwischen Berechnungen und praktischen Ergebnissen. *Vakuumtechnik,* 1981, vol. 30, 106